# EUROPÄISCHE PATENTANMELDUNG

(11) **EP 2 091 117 A2**
(43) Veröffentlichungstag der Anmeldung: **19.08.2009**
(21) Anmeldenummer: 09152076.7
(22) Anmeldetag: 04.02.2009
(51) Int. Cl.: H01S 5/022, H01S 5/14, H01S 5/183, H01S 5/04, H01S 5/06

(54) **Halbleiterlasermodul**

(30) Priorität: 14.02.2008 DE 102008009110
(71) Anmelder: OSRAM Opto Semiconductors GmbH, 93055 Regensburg (DE)
(72) Erfinder: Schwarz, Thomas, 93055 Regensburg (DE); Schulz, Roland, 93059 Regensburg (DE); Unold, Heiko, 93073 Neutraubling (DE); Steegmüller, Ulrich, Northville, MI 48167 (US); Kühnelt, Michael, 93051 Regensburg (DE); Dachs, Jürgen, 85107 Baar-Ebenhausen (DE)
(74) Vertreter: Epping - Hermann - Fischer

(57) **Zusammenfassung**

Halbleiterlasermodul aufweisend
- einen Modulträger (20) mit einer Montagefläche (21),
- eine Pumpvorrichtung (1), die auf der Montagefläche (21) angeordnet ist,

- einen oberflächenemittierenden Haibleiterlaser (40), der auf der Montagefläche (21) angeordnet ist,
- eine Freguenz-Konversions-Vorrichtung (6), die auf der Montagefläche (21) angeordnet ist,
wobei die Montagefläche (21) des Modulträgers (20) einen Flächeninhalt von höchstens 100 mm2 aufweist, und wobei der oberflächenemittierenden Halbleiterlaser (40) aufweist:
- einen Montageblock (3), der eine Oberseite (131) und eine Montagefläche (130) aufweist, und
- zumindest einen Halbleiterlaserchip (4), der auf der Oberseite (131) des Montageblocks (3) angeordnet ist, wobei
- die Montagefläche (130) des Montageblocks (3) im Wesentlichen senkrecht zur Oberseite (131) des Montageblocks verläuft und wobei
- der oberflächenemittierende Halbleiterlaser (40) mit der Montagefläche (130) des Montageblocks (3) auf der Montagefläche (21) des Modulträgers (20) befestigt ist.

## Beschreibung

Es wird ein Halbleiterlasermodul angegeben.

Die Druckschrift EP 1125350 beschreibt ein Halbleiterlasermodul.

Eine zu lösende Aufgabe besteht darin, ein besonderes kompaktes Halbleiterlasermodul anzugeben.

Gemäß zumindest einer Ausführungsform des Halbleiterlasermoduls umfasst das Halbleiterlasermodul einen Modulträger. Bei dem Modulträger handelt es sich beispielsweise um eine Platine aus DBC (direct bonded copper) oder um eine Platte aus einem elektrisch isolierenden, beispielsweise keramischen Material deren Oberfläche stellenweise mit Metallisierungen, versehen sein können.

Der Modulträger weist eine Montagefläche auf. Die Montagefläche ist durch einen Teil der Oberfläche des Modulträgers gegeben. Beispielsweise ist die Montagefläche durch eine Oberseite des Modulträgers gebildet.

Gemäß zumindest einer Ausführungsform des Halbleiterlasermoduls ist eine Pumpvorrichtung auf der Montagefläche angeordnet. Die Pumpvorrichtung umfasst beispielsweise eine Pumpstrahlquelle wie einen kantenemittierenden Halbleiterlaserchip sowie eine Wärmesenke, auf welche die Pumpquelle aufgebracht ist. Die Pumpvorrichtung ist vorzugsweise mechanisch fest auf der Montagefläche befestigt. Beispielsweise kann die Pumpvorrichtung auf die Montagefläche des Modulträgers gelötet oder geklebt sein.

Gemäß zumindest einer Ausführungsform des Halbleiterlasermoduls umfasst das Halbleiterlasermodul einen oberflächenemittierenden Halbleiterlaser. Der oberflächenemittierende Halbleiterlaser umfasst beispielsweise einen Montageblock sowie zumindest einen Halbleiterlaserchip, welcher am Montageblock befestigt ist. Der zumindest eine Halbleiterlaserchip ist dabei vorzugsweise durch die Pumpquelle der Pumpvorrichtung optisch pumpbar. Auf diese Weise kann vom Halbleiterlaserchip Laserstrahlung erzeugt werden. Der oberflächenemittierende Halbleiterlaser ist vorzugsweise auf der Montagefläche des Modulträgers mechanisch fest befestigt. Dazu kann der oberflächenemittierende Halbleiterlaser auf die Montagefläche aufgelötet oder aufgeklebt sein.

Gemäß zumindest einer Ausführungsform des Halbleiterlasermoduls umfasst das Halbleiterlasermodul eine Frequenz-Konversions-Vorrichtung, die auf der Montagefläche angeordnet ist. Die Frequenz-Konversions-Vorrichtung umfasst vorzugsweise einen optisch nicht-linearen Kristall, der zur Frequenzvervielfachung, beispielsweise zur Frequenzverdoppelung, der durch ihn tretenden Laserstrahlung geeignet und vorgesehen ist. Die Frequenz-Konversions-Vorrichtung ist vorzugsweise mechanisch fest auf der Montagefläche des Modulträgers befestigt. Sie kann beispielsweise aufgelötet oder aufgeklebt sein.

Gemäß zumindest einer Ausführungsform des Halbleiterlasermoduls weist die Montagefläche des Modulträgers einen Flächeninhalt von höchstens 100 mm² auf.

Beispielsweise handelt es sich bei dem Modulträger um einen Quader. Die Montagefläche ist dann durch die Oberseite des Quaders gebildet. Die Montagefläche weist dabei einen Flächeninhalt von höchstens 100 mm² auf. Vorzugsweise weist die Montagefläche einen Flächeninhalt von höchstens 85 mm², besonders bevorzugt von höchstens 70 mm² auf.

Gemäß zumindest einer Ausführungsform des Halbleiterlasermoduls umfasst das Halbleiterlasermodul einen Modulträger mit einer Montagefläche, eine Pumpvorrichtung, die auf der Montagefläche angeordnet ist, einen oberflächenemittierenden Halbleiterlaser, der auf der Montagefläche angeordnet ist, und eine Frequenz-Konversions-Vorrichtung, die auf der Montagefläche angeordnet ist. Dabei weist die Montagefläche des Modulträgers einen Flächeninhalt von höchstens 100 mm² auf.

Bei der Montagefläche handelt es sich vorzugsweise um eine plane Fläche. Beispielsweise sind sämtliche Komponenten des Halbleiterlasermoduls auf der Montagefläche angeordnet und mechanisch fest mit der Montagefläche verbunden. Insbesondere weist das Halbleiterlasermodul vorzugsweise nur eine einzige Ebene - die Ebene der Montagefläche - auf, in welcher die Komponenten des Halbleiterlasermoduls wie die Pumpvorrichtung, der oberflächenemittierende Halbleiterlaser, die Frequenz-Konversions-Vorrichtung, und weitere beispielsweise optische Elemente angeordnet sind. Bevorzugt entspricht die Montagefläche der Grundfläche des Halbleiterlasermoduls.

Gemäß zumindest einer Ausführungsform des Halbleiterlasermoduls weist das Halbleiterlasermodul eine Höhe von höchstens 3,5 mm, vorzugsweise von höchstens 3 mm auf. Unter der Höhe des Halbleiterlasermoduls ist dabei die maximale Erstreckung des Halbleiterlasermoduls in einer Richtung zu verstehen, welche senkrecht zur Montagefläche verläuft. Das heißt, der Abstand vom niedrigsten Punkt des Halbleiterlasermoduls zum höchsten Punkt des Halbleiterlasermoduls beträgt vorzugsweise höchstens 3,5 mm. Dabei ist der niedrigste Punkt des Halbleiterlasermoduls beispielsweise durch die der Montagefläche abgewandte Seite des Modulträgers gebildet. Der höchste Punkt des Halbleiterlasermoduls ist dann beispielsweise durch einen Punkt gegeben, der auf derjenigen Komponente des Halbleiterlasermoduls angeordnet ist, welche dem Modulträger am höchsten überragt.

Gemäß zumindest einer Ausführungsform des Halbleiterlasermoduls umfasst der oberflächenemittierende Halbleiterlaser, der auf dem Halbeiterlasermodul aufgebracht ist, einen Montageblock, der eine Oberseite und eine Montagefläche aufweist, wobei zumindest ein Halbleiterlaserchip auf der Oberseite des Montageblocks angeordnet ist. Beispielsweise kann der Halbleiterlaserchip direkt auf die Oberseite des Montageblocks aufgebracht sein. Darüber hinaus ist es auch möglich, dass zwischen der Oberseite des Montageblocks und dem Halbleiterlaserchip eine Wärmesenke angeordnet ist, welche mechanisch fest mit der Oberseite des Montageblocks sowie dem zumindest einen Halbleiterlaserchip verbunden ist.

Die Montagefläche des Montageblocks verläuft dabei im Wesentlichen senkrecht zur Oberseite des Montageblocks. Im Wesentlichen senkrecht heißt dabei, dass der Winkelfehler, das heißt die Abweichung vom 90° Winkel, höchstens 0,3° beträgt. Der Montageblock ist dabei mit seiner Montagefläche auf der Montagefläche des Modulträgers des Halbleiterlasermoduls angeordnet und mechanisch befestigt. Der oberflächenemittierende Halbleiterlaser ist also derart auf dem Modulträger des Halbleiterträgermoduls angeordnet, dass der Halbleiterlaserchip des oberflächenemittierenden Halbleiterlasers die von ihm erzeugte Laserstrahlung parallel oder im Wesentlichen parallel zur Montagefläche des Modulträgers abstrahlen kann.

Gemäß zumindest einer Ausführungsform des Halbleiterlasermoduls ist die Montagefläche des Montageblocks des oberflächenemittierenden Halbleiterlasers durch einen Vereinzelungsprozess erzeugt. Beispielsweise kann die Montagefläche durch einen Lasertrennprozess oder Sägen erzeugt sein. Die Montagefläche kann daher Spuren eines Vereinzelungsprozesses aufweisen. Beispielsweise können Halbeiterlaserchips auf eine Trägerscheibe aufgebracht werden, welche anschließend durch den Vereinzelungsprozess zu Montageblocks, auf deren Oberseite zumindest ein Halbleiterlaserchip angeordnet ist, vereinzelt wird. Auf diese Weise kann eine Vielzahl oberflächenemittierender Halbleiterlaser erzeugt werden, welche sich durch eine besonders geringe Größe auszeichnen. Diese Halbleiterlaser eignen sich daher besonders gut zur Schaffung eines kompakten Halbleiterlasermoduls.

Gemäß zumindest einer Ausführungsform des Halbleiterlasermoduls besteht der Montageblock aus einem nicht-metallischen Material oder enthält ein nicht-metallisches Material. Vorzugsweise enthält der Montageblock ein Halbleitermaterial oder ein keramisches Material oder der Montageblock besteht aus einem Halbleitermaterial oder einem keramischen Material. Diese nicht-metallischen Materialien eignen sich besonders gut, um aus einer größeren Trägerscheibe zu einzelnen Montageblocks vereinzelt zu werden. Diese nicht-metallischen Materialien sind daher besonders gut geeignet zur Herstellung eines Montageblocks für einen Halbleiterlaserchip, der in einem besonders kompakten Halbleiterlasermodul eingesetzt werden kann.

Gemäß zumindest einer Ausführungsform des Halbleiterlasermoduls weist der Montageblock eine im Wesentlichen gleichmäßige Dicke von wenigstens 0,5 mm und höchstens 1,7 mm auf. Die Dicke des Montageblocks ist dabei der Abstand seiner Oberseite von der der Oberseite gegenüberliegenden Unterseite. Eine "im Wesentlichen gleichmäßige Dicke" heißt, dass Ober- und Unterseite des Montageblocks parallel, oder im Wesentlichen parallel zueinander laufen. "Im Wesentlichen parallel" heißt dabei dass Ober- und Unterseite um einen Winkelfehler von höchstens 0,1° von einem plan-parallelen Verlauf abweichen. Ein Montageblock solch geringer Dicke eignet sich besonders gut zum Einsatz in einem kompakten Halbleiterlasermodul mit kleinem Flächeninhalt der Montagefläche.

Gemäß zumindest einer Ausführungsform des Halbleiterlasermoduls weist das Halbleiterlasermodul ferner ein Etalon auf. Das Etalon findet bevorzugt als frequenzselektives Element im Halbleiterlasermodul Anwendung. Das Etalon ist dabei auf der Montagefläche des Modulträgers angeordnet. Das Etalon ist vorzugsweise auf der Montagefläche des Modulträgers mechanisch befestigt, beispielsweise angelötet oder angeklebt.

Gemäß zumindest einer Ausführungsform des Halbleiterlasermoduls umfasst das Etalon einen Träger und eine Etalon-Schicht. Die Etalon-Schicht besteht beispielsweise aus einem Glas, das auf dem Träger befestigt ist. Insbesondere kann das Glas auf dem Etalon-Träger gebondet sein. Die Etalon-Schicht, das heißt das Glas aus dem die Etalon-Schicht besteht, weist dabei eine gleichmäßige Dicke von vorzugsweise wenigstens 20 µm und vorzugsweise höchstens 50 µm auf. Beispielsweise weist die Etalon-Schicht eine Dicke von 30 µm auf.

Gemäß zumindest einer Ausführungsform des Halbleiterlasermoduls enthält oder besteht der Etalon-Träger aus zumindest einem der folgenden Materialien: Silizium, Glas. Diese Materialien eignen sich besonders gut, um eine aus Glas bestehende Etalon-Schicht mittels Bonden auf dem Träger zu befestigen. Ferner kann aus diesen Materialien ein besonders dünner und damit sehr kompakter Etalon-Träger geschaffen werden. Beispielsweise weist das Etalon eine konstante Dicke in Strahlrichtung von höchstens 0,7 mm auf. Das heißt die Dicke des Trägers und die Dicke der Etalon-Schicht summieren sich zu einer Gesamtdicke des Etalons von höchstens 0,7 mm. Vorzugsweise weist das Etalon dabei eine Dicke von wenigstens 0,3 mm und höchsten 0,7 mm auf. Dadurch ist eine ausreichend mechanische Stabilität des Etalons gewährleistet.

Der Träger weist dabei eine gleichmäßige Höhe und Breite von je zwischen 1,0 mm und 1,7 mm, beispielsweise von je 1,5 mm auf.

Der Träger weist ferner eine Aussparung auf, durch welche der Laserstrahl ausschließlich durch die Etalon-Schicht treten kann. Der Durchmesser der Aussparung beträgt zwischen wenigstens 0,5 mm und höchstens 0,8 mm.

Insgesamt eignet sich das beschriebene Etalon besonders gut, um ein kompaktes Halbleiterlasermodul zu schaffen, das eine Montagefläche mit besonders geringer Grundfläche aufweist.

Gemäß zumindest einer Ausführungsform des Halbleiterlasermoduls ist das Etalon derart angeordnet, dass im Betrieb des Halbleiterlasermoduls keine frequenzkonvertierte Strahlung durch die Etalon-Schicht tritt. Das Etalon kann dazu beispielsweise im Strahlengang zwischen dem oberflächenemittierenden Halbleiterlaser und einem optischen Element angeordnet sein, welches die Laserstrahlung des oberflächenemittierenden Halbleiterlasers in einen Teil des Laserresonators des Halbleiterlasermoduls einkoppelt, in welchem sich die Frequenz-Konversions-Vorrichtung befindet.

Gemäß zumindest einer Ausführungsform des Halbleiterlasermoduls weist der Resonator des Halbleiterlasermoduls eine Länge von höchstens 10 mm auf. Eine solch geringe Länge des Laserresonators ist durch die hier beschriebene besonders kompakte Anordnung der Komponenten des Halbleiterlasermoduls ermöglicht. Die geringe Resonatorlänge erlaubt dabei hohe Modulationsfrequenzen der erzeugten Laserstrahlung von > 40 MHz, wodurch sich das Halbleiterlasermodul insbesondere für Anwendungen in der Bildprojektion besonders gut eignet.

Im Folgenden wird das hier beschriebene Halbleiterlasermodul anhand von Ausführungsbeispielen und den dazugehörigen Figuren näher erläutert.

Die Figuren 1A bis 1C zeigen ein erstes Ausführungsbeispiel eines hier beschriebenen Halbleiterlasermoduls.

Die Figuren 2A und 2B zeigen ein zweites Ausführungsbeispiel eines hier beschriebenen Halbleiterlasermoduls.

Die Figur 3 zeigt ein drittes Ausführungsbeispiel eines hier beschriebenen Halbleiterlasermoduls.

Die Figur 4 zeigt ein viertes Ausführungsbeispiel eines hier beschriebenen Halbleiterlasermoduls.

Die Figuren 5A bis 5D beschreiben ein Herstellungsverfahren für einen in einem Ausführungsbeispiel eines hier beschriebenen Halbleiterlasermoduls eingesetzten Halbleiterlaser.

Die Figuren 6A und 6B zeigen ein Etalon, wie es in einem Ausführungsbeispiel eines hier beschriebenen Halbleiterlasermoduls zum Einsatz kommt.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

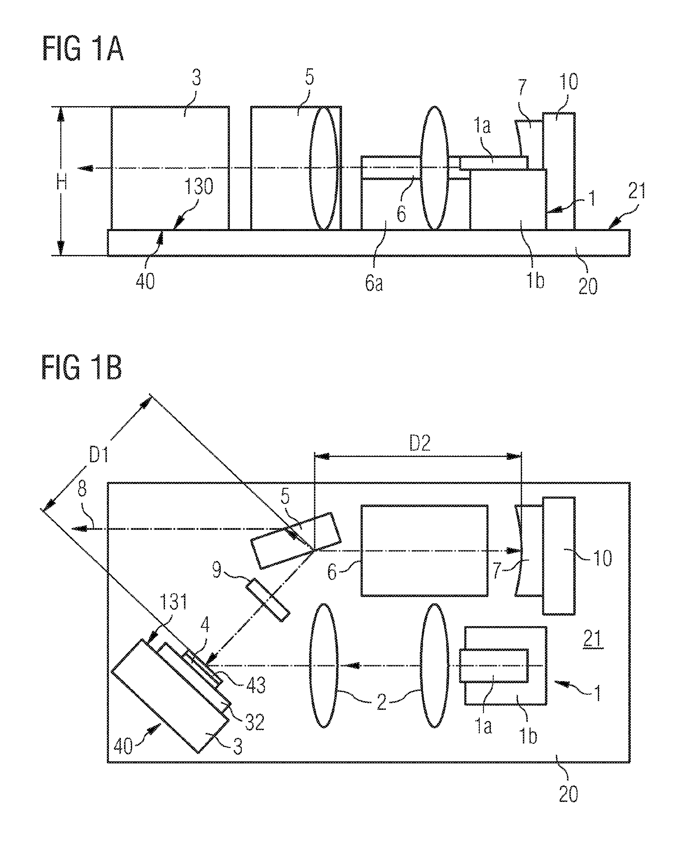

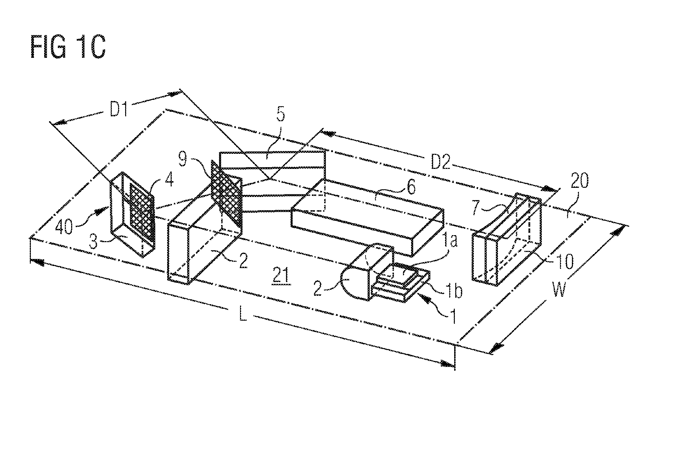

Anhand der Figuren 1A bis 1C ist ein erstes Ausführungsbeispiel eines hier beschriebenen Halbleiterlasermoduls näher erläutert. Die Figur 1A zeigt das Halbleiterlasermodul gemäß dem ersten Ausführungsbeispiel in einer schematischen Seitenansicht. Die Figur 1B zeigt das Halbleiterlasermodul in einer schematischen Draufsicht. Die Figur 1C zeigt das Halbleiterlasermodul in einer schematischen Perspektivdarstellung. Das Halbleiterlasermodul umfasst einen Modulträger 20. Bei dem Modulträger 20 handelt es sich um eine Platte, die beispielsweise aus Direct Bonded Copper (DBC) besteht. Ferner ist es möglich, dass der Modulträger einen Grundkörper aus einem keramischen Material wie Aluminiumnitrid (AlN) aufweist, welcher an Oberseite und Unterseite Metallisierungen aufweist, die beispielsweise aus Kupfer bestehen und eine Dicke zwischen 0,1 mm und 0,3 mm vorzugsweise 0,2 mm aufweisen.

Der Modulträger 20 weist eine Montagefläche 21 auf, welche durch die Oberseite des Modulträgers 20 gebildet ist. Die Grundfläche der Montagefläche und damit die Grundfläche des Modulträgers 20 beträgt vorzugsweise höchstens 100 mm², besonders bevorzugt höchstens 70 mm². Beispielsweise weist die Montagefläche eine Länge L von 11 mm auf und eine Breite W von 6 mm auf.

Auf die Montagefläche 21 sind die Komponenten des Halbleiterlasermoduls aufgebracht. Auf die Montagefläche 21 ist beispielsweise eine Pumpvorrichtung 1 aufgebracht. Die Pumpvorrichtung 1 umfasst eine Pumpquelle 1a und eine Wärmesenke 1b. Die Pumpquelle 1a ist auf der der Montagefläche 21 abgewanden Seite der Wärmesenke 1b befestigt. Die Wärmesenke 1b ist mit ihrer der Pumpquelle 1a abgewandten Seite auf die Montagefläche 21 aufgebracht, beispielsweise aufgelötet oder aufgeklebt. Die Pumpquelle 1a erzeugt stark divergentes Pumplicht. Bei der Pumpquelle 1a handelt es sich beispielsweise um einen kantenemittierenden Halbleiterlaser wie einen Breitstreifenlaser mit wenigstens einem Emitterbereich. Von der Pumpquelle im Betrieb erzeugte Pumpstrahlung wird durch die Pumpoptiken 2 auf den Halbleiterlaserchip 4 fokussiert.

Der Halbleiterlaserchip 4 ist Teil des Halbleiterlasers 40. Der Halbleiterlaser 40 umfasst einen Montageblock 3, welcher mit seiner Montageflächen 130 auf der Montagefläche 21 des Modulträgers 20 befestigt, zum Beispiel angelötet oder angeklebt ist. Der Halbleiterlaserchip 4 ist auf eine Wärmesenke 32 aufgebracht, welche auf der Oberseite 131 des Montageblocks 3 befestigt ist. Die Wärmesenke 32 ist dabei optional. Das heißt der Halbleiterlaserchip 4 kann auch direkt auf den Montageblock 3 aufgebracht und dort befestigt sein. Der Halbleiterlaserchip 4 ist auf dem Montageblock 3 beziehungsweise der Wärmesenke 32 durch Kleben, Löten oder Bonden montiert. Die Pumpstrahlung ist derart durch die Pumpoptik 2 auf den Halbleiterlaserchip 4 fokussiert, dass dort ein Pumpspot mit einem Radius zwischen zirka 25 µm und höchstens 60 µm erzeugt wird. Bei dem Halbleiterlaserchip 4 handelt es sich um einen oberflächenemittierenden Halbleiterlaserchip (VECSEL), welcher durch die Pumpquelle 1a optisch gepumpt wird. Im Betrieb des Halbleiterlaserchips 4 erfolgt der Wärmefluss durch den Montageblock um einen 90° Winkel zum Modulträger 20 hin.

Der Resonator des Halbleiterlasermoduls ist durch einen Bragg-Spiegel 43 des Halbleiterlaserchips 4 und den Endspiegel 7 definiert. Die reflektierende Oberfläche des Endspiegels 7 umfasst dabei eine Beschichtung, die hoch reflektierend ist für die vom Halbleiterlaserchip erzeugte elektromagnetische Strahlung der Grundwellenlänge und eine Beschichtung die hoch reflektierend ist für die von der Frequenz-Konversions-Vorrichtung 6 wellenlängenkonvertierte elektromagnetische Strahlung. Der Halbleiterlaserchip 4 erzeugt dabei beispielsweise elektromagnetische Strahlung im Spektralbereich für Infrarotstrahlung, welche von der Frequenz-Konversions-Vorrichtung 6 zu elektromagnetischer Strahlung im Spektralbereich grünen Lichts konvertiert wird. Beispielsweise weist das Pumplicht 1c eine Wellenlänge von 808 nm auf, der Halbleiterlaserchip 4 erzeugt Strahlung der Wellenlänge 1060 nm und die Frequenz-Konversions-Vorrichtung 6 erzeugt Strahlung der Wellenlänge 530 nm.

Das Halbleiterlasermodul weist eine Höhe H von höchstens 3,5 mm, vorzugsweise höchstens 3 mm, besonders bevorzugt höchstens 2,5 mm auf. Die Höhe H ist dabei der Abstand von der der Montagefläche 21 abgewandten Unterseite des Modulträgers 20 zum höchsten Punkt des Halbleiterlasermoduls welcher beispielsweise durch eine Komponente des Halbleiterlasermoduls wie den Halbleiterlaser 40 gebildet ist.

Der Resonator weist eine Länge D1 plus D2 auf, die höchstens 10 mm beträgt.

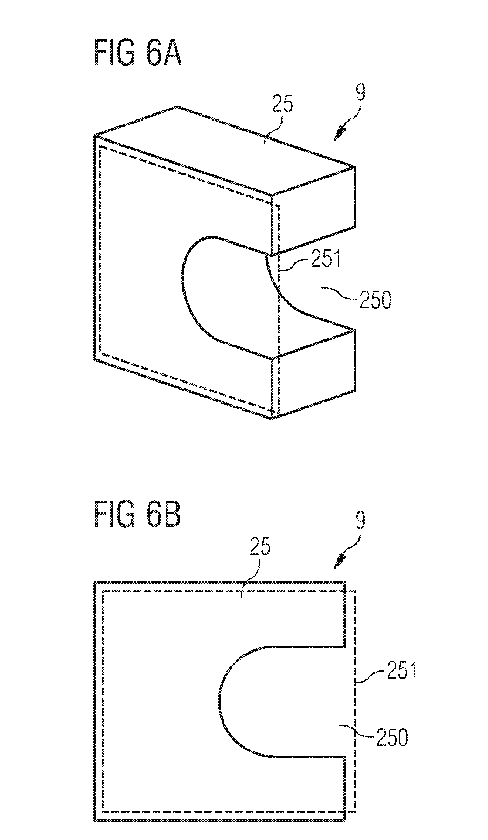

Im Resonator ist ein wellenlängenselektives Element, beispielsweise ein Etalon 9 angeordnet. Das Etalon 9 ist in Verbindung mit den Figur 6A und 6B näher beschrieben. Es umfasst eine Etalon-Schicht, welche aus Glas besteht und in Strahlrichtung wenigstens 10 µm, vorzugsweise zirka 30 µm dick ist.

Ferner ist im Resonator die Frequenz-Konversions-Vorrichtung 6 angeordnet, welche einen optisch nicht-linearen Kristall umfasst. Darüber hinaus kann die Frequenz-Konversions-Vorrichtung 6 eine Heizvorrichtung 6a umfassen, welche zwischen dem optisch nicht-linearen Kristall und dem Modulträger 20 auf der Montagefläche 21 angeordnet ist. Die Heizvorrichtung 6a hält den optisch nicht-linearen Kristall auf einer gleichmäßigen Temperatur von beispielsweise oberhalb 45°C.

Die Auskopplung der frequenzkonvertierten Laserstrahlung - also beispielsweise der grünen Laserstrahlung - erfolgt durch den Auskoppler 5, der zugleich als Faltungsspiegel zur Polarisationsselektion dient. Der Auskoppler 5 weist eine Beschichtung auf, welche für elektromagnetische Strahlung der Grundwellenlänge hoch reflektierend ist. Ferner weist der Auskoppler 5 eine Beschichtung auf, welche für frequenzkonvertierte Strahlung antireflektierend ausgebildet ist. Auf diese Weise wird elektromagnetische Strahlung der Grundwellenlänge im Resonator gehalten, wohingegen frequenzkonvertierte Strahlung 8 durch den Auskoppler 5 das Halbleiterlasermodul verlassen kann. Der Auskoppler 5 ist im vorliegenden Ausführungsbeispiel als Planspiegel für die elektromagnetische Strahlung der Grundwellenlänge ausgeführt. Die für die Strahlung der Grundfrequenz hoch reflektierend ausgebildete Beschichtung des Auskopplers 5 kann polarisationsfestlegend ausgeführt sein. Dadurch dient der Auskoppler 5 auch zum Polarisationspinning der im Resonator umlaufenden Strahlung. Optional kann der Auskoppler 5 im Brewster-Winkel angeordnet sein, was ebenfalls die Polarisation der umlaufenden Laserstrahlung festlegt.

Prinzipiell können als Faltungswinkel am Auskoppler 5 für die elektromagnetische Strahlung der Grundwellenlänge alle Winkel zwischen 10 und 180° Verwendung finden, vorliegend wird ein Winkel von 135° verwendet.

Der Endspiegel 7 ist beim in Verbindung mit den Figuren 1A bis 1C beschriebenen Ausführungsbeispiel auf einem Spiegel-Montageblock 10 angeordnet, der beispielsweise aus Silizium, Glas oder Aluminiumnitrid bestehen kann. Der Spiegel-Montageblock ist dabei optional.

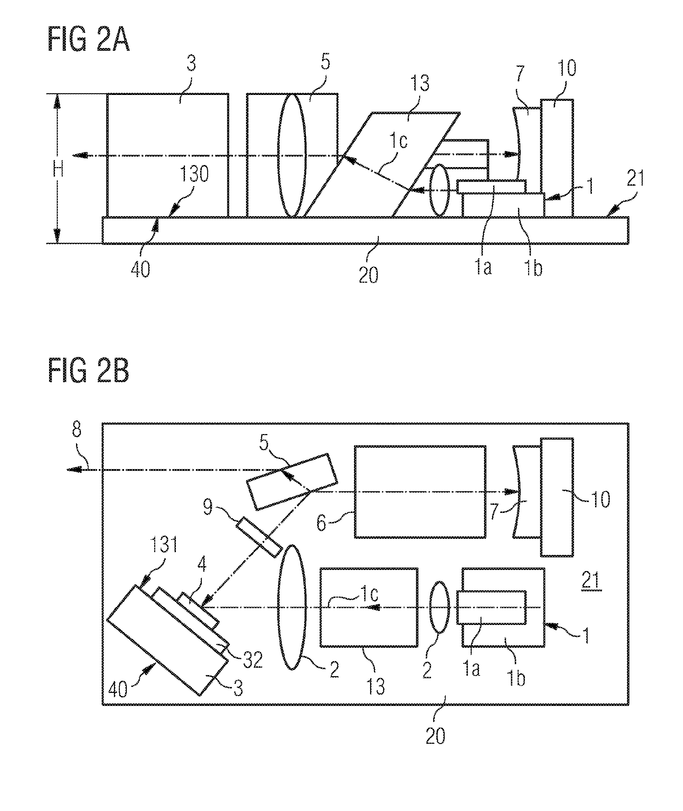

In Verbindung mit den Figuren 2A und 2B ist ein weiteres Ausführungsbeispiel eines hier beschriebenen Halbleiterlasermoduls beschrieben. In diesem Ausführungsbeispiel befindet sich der Pumppfad näher an der Montagefläche 21 als im in Verbindung mit den Figuren 1A bis 1C beschriebenen Ausführungsbeispiel. Das heißt die von der Pumpvorrichtung 1 erzeugte Pumpstrahlung 1C ist näher an der Montagefläche 21 als im in Verbindung mit den Figuren 1A bis 1C beschriebenen Ausführungsbeispiel. In diesem Fall wird die Pumpstrahlung 1c mittels eines Strahlanhebers 13 gehoben. Bei dem Strahlanheber handelt es sich beispielsweise um ein Parallelepiped. Der Vorteil dieser Ausführungsform besteht darin, dass eine dünnere Wärmesenke 1b für die Pumpquelle 1a Verwendung findet und die Pumpoptik 2, welche der Pumpvorrichtung 1 am nächsten liegt, direkt auf der Montagefläche 21 angeordnet werden kann, ohne dass ein Montagesockel zum Anheben dieser Pumpoptik notwendig ist.

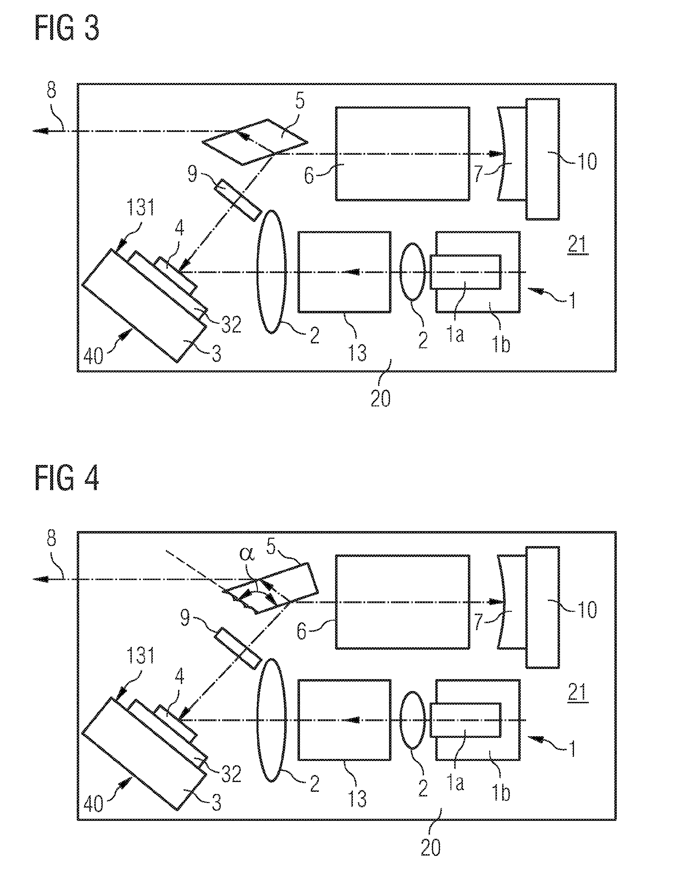

In Verbindung mit der Figur 3 ist ein drittes Ausführungsbeispiel eines hier beschriebenen Halbleiterlasermoduls näher erläutert. In diesem Ausführungsbeispiel ist der Auskoppler 5 nicht durch einen Planspiegel, sondern durch ein Parallelepiped gebildet. Das Parallelepiped zeichnet sich durch eine reduzierte Größe aus, so dass mehr Platz beispielsweise zur Montage des Etalons 9 vorhanden ist. Alternativ oder zusätzlich zu einem Etalon kann auch ein anderes frequenzselektives Element wie zum Beispiel ein doppelbrechendes Filter zum Einsatz kommen.

In Verbindung mit der Figur 4 ist ein viertes Ausführungsbeispiel eines hier beschriebenen Halbleiterlasermoduls erläutert. In Abwandlung zum Ausführungsbeispiel der Figuren 2A und 2B wird im Ausführungsbeispiel der Figur 4 als Auskoppler 5 ein Planspiegel verwendet, welcher winkelförmig abgeschnitten ist, um dadurch mehr Platz für das Etalon zu schaffen. Das heißt, der Winkel α ist mittels Sägen hergestellt. Der Planspiegel weist daher Vereinzelungsspuren vom Sägen auf, welche in der Figur schematisch dargestellt sind.

Insgesamt zeichnet sich das hier beschriebene Halbleiterlasermodul durch eine besonders geringe Größe aus. Das heißt, der Bauraum, der zum Einsatz des Halbleiterlasermoduls zur Verfügung gestellt werden muss, ist besonders klein. Das Halbleiterlasermodul kann daher beispielsweise als Teil einer optischen Projektionsvorrichtung in Kleingeräten wie Mobiltelefonen, Notebooks, Laptops oder Spielkonsolen Verwendung finden.

Die Integration des Etalons 9 in den reinen Pfad für die elektromagnetische Strahlung der Grundwellenlänge, das heißt zwischen dem Halbleiterlaser 40 und dem Auskoppler 5, erweist sich als besonders vorteilhaft, da dadurch keine Verluste in der frequenzkonvertierten Strahlung 8 entstehen. Das Etalon ist derart angeordnet, dass lediglich Strahlung der Grundwellenlänge, welche nicht durch die Frequenz-Konversions-Vorrichtung 6 wellenlängenkonvertiert wurde, durch das Etalon 9 tritt.

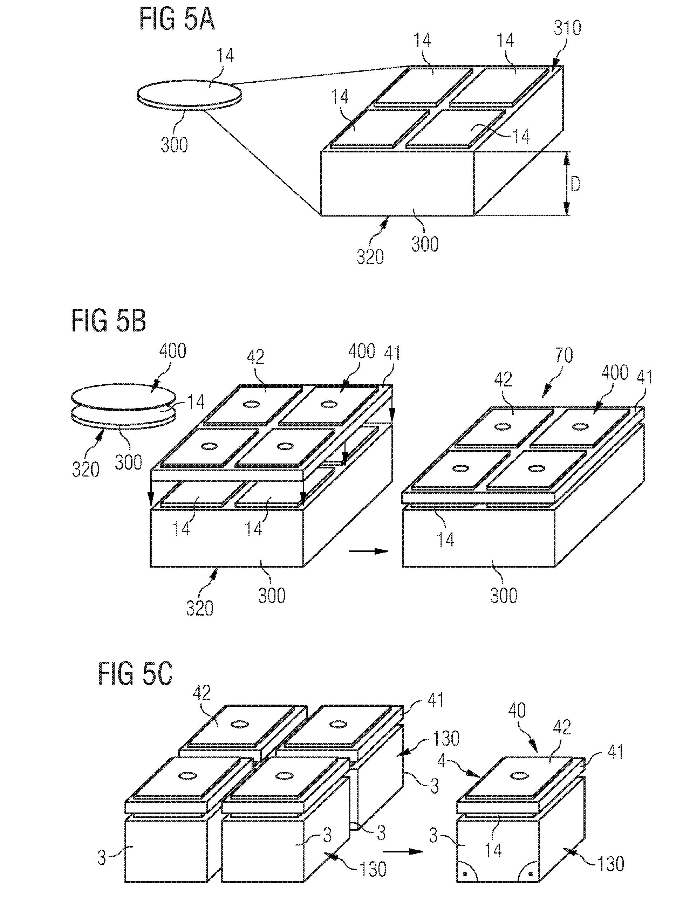

Die Figur 5A zeigt in einer schematischen Perspektivdarstellung einen ersten Verfahrensschritt zur Herstellung einer Vielzahl von Halbleiterlasern, wie sie in einem hier beschriebenen Halbleiterlasermodul zum Einsatz kommen. In diesem ersten Verfahrensschritt wird zunächst eine Trägerscheibe 300 bereitgestellt. Die Trägerscheibe 300 besteht aus Silizium oder Aluminiumnitrid. Die Trägerscheibe 300 weist eine gleichmäßige Dicke D auf. Die Dicke liegt dabei vorzugsweise zwischen 0,4 mm und 1,5 mm. Die Trägerscheibe umfasst eine Oberseite 310 und eine Unterseite 320. Oberseite 310 und Unterseite 320 der Trägerscheibe 300 verlaufen im Wesentlichen plan-parallel zueinander. Das heißt, die Abweichung von der Plan-Parallelität beträgt vorzugsweise weniger als 0,1°. Die Figur 5A zeigt dabei links die gesamte Trägerscheibe sowie rechts einen vergrößert dargestellten Ausschnitt aus der Trägerscheibe.

Auf die Oberseite 310 der Trägerscheibe ist eine Kontaktmetallisierung 14 aufgebracht, welche durch rechteckige TiPtAu-Kontaktflächen gebildet ist. Die Kontaktmetallisierung dient zu einem späteren mechanischen Befestigen von Halbleiterlaserchips.

In Verbindung mit der Figur 5B ist anhand schematischer Perspektivzeichnungen ein weiterer Verfahrensschritt zur Herstellung einer Vielzahl von Halbleiterlasern beschrieben. In diesem Verfahrensschritt wird ein Wafer-Verbund 400 von Halbleiterlaserchips 4 auf die Trägerscheibe 300 aufgebracht. Der Wafer-Verbund 400 weist dabei auf seiner der Trägerscheibe 300 zugewandten Rückseite eine Lotmetallisierung auf, welche in den Figuren nicht dargestellt ist.

Der Wafer-Verbund 400 von Halbleiterlaserchips besteht dabei beispielsweise aus einem Aufwachssubstrat 41, auf das epitaktisch abgeschiedene Schichten aufgebracht sind. Die epitaktisch abgeschiedenen Schichten umfassen dabei unter anderem aktive Schichten, welche zur Erzeugung von Laserstrahlung geeignet sind.

Der Wafer-Verbund wird mit einer Genauigkeit von wenigen Mikrometern auf die Trägerscheibe 300 aufgebracht. Anschließend wird die Lotmetallisierung des Wafer-Verbunds mit der Kontaktmetallisierung 14 verlötet, so dass eine mechanisch feste Verbindung, also ein Verbund 70 von Wafer-Verbund 400 und Trägerscheibe 300 erzeugt wird.

Vorzugsweise ist auf die dem Wafer-Verbund 400 abgewandte Unterseite 320 der Trägerscheibe 300 eine klebende Sägefolie aufgebracht, welche in einem Rahmen eingespannt ist.

In Verbindung mit der Verbindung mit der Figur 5C ist in einer schematischen Perspektivdarstellung ein weiterer Verfahrensschritt des Verfahrens beschrieben. In diesem Verfahrensschritt wird der Verbund aus Wafer-Verbund 400 und Trägerscheibe 300 zu einzelnen Halbleiterlasern 40 umfassend einen Montageblock und einen Halbleiterlaserchip 4 vereinzelt. Die Vereinzelung kann beispielsweise durch ein Lasertrennverfahren oder Wafersägen erfolgen. Nach dem Sägen wird die Sägefolie, auf welche der Verbund 70 aufgebracht ist, expandiert. Auf diese Weise trennen sich die einzelnen Chips entlang der Vereinzelungslinien voneinander. Durch das Vereinzeln werden Montageflächen 130 einzelner Montageblocks 3 erzeugt. Aufgrund des verwendeten Materials für die Trägerscheibe 300 und des verwendeten Vereinzelungsprozesses sind die Montageflächen 130 sehr eben ausgebildet und weisen höchstens einen geringen Winkelfehler gegen die Senkrechte zur Oberseite 131 des Montageblocks 3 auf. Der Winkelfehler beträgt dabei weniger als 0,3°.

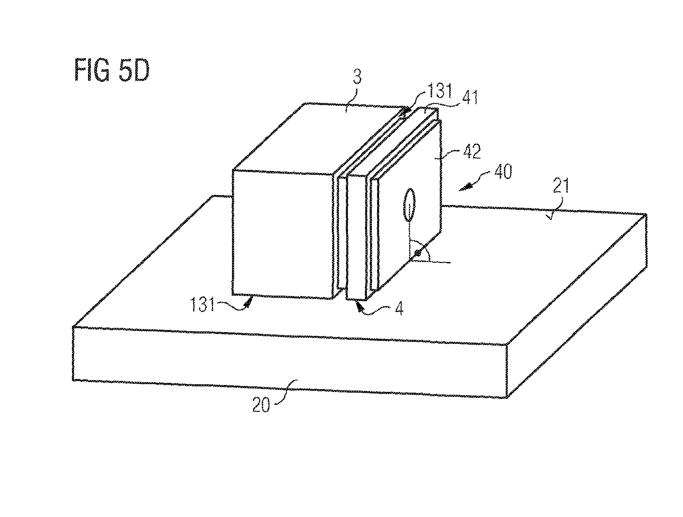

Die Figur 5D zeigt in einer schematischen Perspektivdarstellung einen gemäß dem Verfahren hergestellten Halbleiterlaser 40, welcher mit seiner Montagefläche 130 auf den Modulträger 20 montiert ist. Wie aus der Figur 5D ersichtlich, bilden - aufgrund des geringen Winkelfehlers - die dem Modulträger 3 abgewandte Oberseite des Halbleiterlaserchips 4 sowie die Montagefläche 21 des Modulträgers 20 einen rechten Winkel miteinander.

Die Figur 6A zeigt in einer schematischen Perspektivdarstellung ein Ausführungsbeispiel eines hier beschriebenen Etalons 9. Das Etalon 9 umfasst einen Träger 25, der beispielsweise aus Silizium oder Glas besteht. Auf den Träger 25 ist eine Etalon-Schicht 251 befestigt. Die Etalon-Schicht 251 besteht vorzugsweise aus einem Glas, beispielsweise aus einem Floatglas. Die Etalon-Schicht 251 kann mittels anodischem Bonden oder Kleben am Träger 25 befestigt sein. Der Träger 25 weist eine Ausnehmung 250 auf. Die Ausnehmung 250 kann vor und nach dem Befestigen der Etalon-Schicht 251 am Träger 25 erzeugt werden. Beispielsweise wird die Ausnehmung nach dem Befestigen der Etalon-Schicht 251 mittels eines Ätzprozess erzeugt. Die Ausnehmung 250 ist an einer Stelle im Träger 25 vorgesehen, an der elektromagnetische Strahlung, die von der Etalon-Schicht 251 frequenzselektiert werden soll, durch die Etalon-Schicht 251 tritt. Der Träger 25 weist mit der Ausnehmung 250 also eine Aussparung auf, durch welche der Laserstrahl ausschließlich durch die Etalon-Schicht treten kann. Der Durchmesser der Ausnehmung 250 beträgt zwischen wenigstens 0,5 mm und höchstens 0,8 mm.

Wie insbesondere auch aus der schematischen Draufsicht in Figur 6B ersichtlich ist, kann die Ausnehmung 250 beispielsweise U-förmig ausgebildet sein.

Die Dicke der Etalon-Schicht 251 beträgt vorzugsweise zwischen 20 und 50 µm, insbesondere 30 µm. Der Träger 25 und die Etalon-Schicht 251 weisen in Summe eine konstante Dicke in Strahlrichtung von vorzugsweise wenigstens 0,2 mm und maximal 1,5 mm auf. Eine solche Dicke des Trägers 25 sorgt für eine ausreichende mechanische Stabilität des Etalons 9.

Diese Patentanmeldung beansprucht die Priorität der deutschen Patentanmeldung DE 102008009110.3, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterlasermodul aufweisend
- einen Modulträger (20) mit einer Montagefläche (21),
- eine Pumpvorrichtung (1), die auf der Montagefläche (21) angeordnet ist,
- einen oberflächenemittierenden Halbleiterlaser (40), der auf der Montagefläche (21) angeordnet ist,
- eine Frequenz-Konversions-Vorrichtung (6), die auf der Montagefläche (21) angeordnet ist,
wobei die Montagefläche (21) des Modulträgers (20) einen Flächeninhalt von höchstens 100 mm² aufweist, und
wobei der oberflächenemittierenden Halbleiterlaser (40) aufweist:
- einen Montageblock (3), der eine Oberseite (131) und eine Montagefläche (130) aufweist, und
- zumindest einen Halbleiterlaserchip (4), der auf der Oberseite (131) des Montageblocks (3) angeordnet ist,
wobei
- die Montagefläche (130) des Montageblocks (3) im Wesentlichen senkrecht zur Oberseite (131) des Montageblocks verläuft und wobei
- der oberflächenemittierende Halbleiterlaser (40) mit der Montagefläche (130) des Montageblocks (3) auf der Montagefläche (21) des Modulträgers (20) befestigt ist.

2. Halbleiterlasermodul nach dem vorherigen Anspruch, bei dem die Höhe (H) des Halbleiterlasermoduls höchstens 3 mm beträgt.

3. Halbleiterlasermodul nach dem vorherigen Anspruch, bei dem die Montagefläche (131) des Montageblocks (3) des oberflächenemittierenden Halbleiterlasers (40) durch einen Vereinzelungsprozess erzeugt ist.

4. Halbleiterlasermodul nach einem der vorherigen Ansprüche, bei dem der Montageblock (3) ein nicht-metallisches Material enthält oder aus einem nicht-metallischen Material besteht.

5. Halbleiterlasermodul nach einem der vorherigen Ansprüche, bei dem der Montageblock (3) eine im Wesentlichen gleichmäßige Dicke (D) von wenigstens 0,5 mm und höchstens 1,7 mm aufweist.

6. Halbleiterlasermodul nach einem der vorherigen Ansprüche, aufweisend ein Etalon (9), das als frequenzselektives Element im Halbleiterlasermodul vorgesehen ist und auf der Montagefläche (21) des Modulträgers (20) angeordnet ist, wobei
- das Etalon eine Etalon-Schicht (251) umfasst, die aus einem Glas besteht, das auf einen Etalon-Träger (25) befestigt, insbesondere gebondet ist, und
- die Etalon-Schicht (251) eine gleichmäßige Dicke von wenigstens 20 µm und höchstens 50 µm, insbesondere 30 µm aufweist.

7. Halbleiterlasermodul nach dem vorherigen Anspruch, bei dem der Etalon-Träger (25) zumindest eines der folgenden Materialien enthält oder aus einem der folgenden Materialien besteht: Silizium, Glas.

8. Halbleiterlasermodul nach einem der vorherigen Ansprüche, bei dem das Etalon (9) eine konstante Dicke von höchstens 0,7 mm aufweist.

9. Halbleiterlasermodul nach einem der vorherigen Ansprüche, bei dem das Etalon (9) derart angeordnet ist, dass im Betrieb des Halbleiterlasermoduls keine frequenzkonvertierte Strahlung (8) durch die Etalon-Schicht (251) tritt.

10. Halbleiterlasermodul nach einem der vorherigen Ansprüche, bei dem die Resonator-Länge (D1+D2) höchsten 10 mm beträgt.
